# EUROPEAN PATENT SPECIFICATION

(11) **EP 1 424 767 B1**
(45) Date of publication and mention of the grant of the patent: **22.05.2013**
(21) Application number: 03078751.9
(22) Date of filing: 28.11.2003
(51) Int. Cl.: H02N 15/00, H01L 41/09, H02N 2/00, G03F 7/20

(54) **Magnetic actuator under piezoelectric control**
Magnetischer Betätiger unter piezoelektrischer Steuerung
Actionneur magnétique sous contrôle piézoélectrique

(30) Priority: 29.11.2002 EP 02079992
(43) Date of publication of application: 02.06.2004
(73) Proprietor: ASML Netherlands B.V., 5504 DR Veldhoven (NL)
(72) Inventor: De Weerdt, Robrecht Emiel Maria Leonia, 2322 Hoogstraten (BE); Dams, Johannes Adrianus Antonius Theodorus, 5508 KC Veldhoven (NL)

(56) References cited:
- EP-A- 0 292 562
- US-A- 5 637 937
- US-A- 5 780 943
- PATENT ABSTRACTS OF JAPAN vol. 010, no. 386 (E-467), 24 December 1986 (1986-12-24) -& JP 61 177155 A (SONY CORP), 8 August 1986 (1986-08-08)
- PATENT ABSTRACTS OF JAPAN vol. 014, no. 520 (E-1002), 14 November 1990 (1990-11-14) -& JP 02 219455 A (FUJITSU LTD), 3 September 1990 (1990-09-03)
- PATENT ABSTRACTS OF JAPAN vol. 007, no. 013 (E-153), 19 January 1983 (1983-01-19) -& JP 57 170094 A (FUJITSU KK), 20 October 1982 (1982-10-20)
- PATENT ABSTRACTS OF JAPAN vol. 1998, no. 08, 30 June 1998 (1998-06-30) -& JP 10 066364 A (CITIZEN WATCH CO LTD), 6 March 1998 (1998-03-06)
- PATENT ABSTRACTS OF JAPAN vol. 2002, no. 12, 12 December 2002 (2002-12-12) -& JP 2002 222758 A (CANON INC), 9 August 2002 (2002-08-09)

## Description

### Field of the invention

The present invention relates to a magnetic actuator for controlling an adjustment force as defined in the preamble of claim 1. Moreover, the present invention also relates to a support system as defined in the preamble of claim 9. Furthermore, the present invention relates to a lithographic projection apparatus as defined in the preamble of claim 10. Also, the present invention relates to a device manufacturing method as defined in the preamble of claim 12.

### Background of the invention

The present invention finds a preferred application in the field of lithographic projection apparatus that encompass a radiation system for supplying a projection beam of radiation, a support structure for supporting patterning means, which serves to pattern the projection beam according to a desired pattern, a substrate table for holding a substrate; and, a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmission mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a visco-elastic control layer and a reflective surface. The basic principle behind such an apparatus is that (for example) addressed areas of the reflective surface reflect incident light as diffracted light, whereas unaddressed areas reflect incident light as non-diffracted light. Using an appropriate filter, the said non-diffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localised electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described here above, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required; and
- A programmable LCD array. An example of such a construction is given in United States Patent US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as set forth here above.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g., an IC. Such a patterned layer may then undergo various processes such as etching, ion-implantation (doping), metallization, oxidation, chemical-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

Within a lithographic projection apparatus supports are required that provide a permanent force to oppose gravity. For instance quasi-static supports are required to support an isolated reference frame (which supports the projection system and various sensor devices) and isolate it from external vibrations. Dynamic supports are, for instance, required to support a short-stroke module for a substrate or patterning means on a long-stroke module. In such dynamic supports a static force component is provided to support the weight of the short-stroke module and a dynamic force component is provided to drive the short-stroke module. In both static and dynamic supports it is important that the support has very low stiffness to prevent the transmission of vibrations.

Previously, it has been proposed to provide a supporting force by means of magnetic attraction and/or repulsion such as, for instance, disclosed in EP 1,001,512 or US 5,780,943. However, the proposed solutions provide a supporting force that may be positional dependent both along and perpendicular to the support direction. The proposed solutions may also be subject to demagnetisation effects.

Further reference can e.g. be made to JP 61-177155 as disclosing a magnetic actuator having a displacing element for relatively displacing a 1^{st} and second magnetic element of the actuator.

The support using magnetic force as introduced in the present text is further referred to as an magnetic actuator that provides a magnetic force. The magnetic actuator serves for supporting a load which must be supported and/or positioned at a well-specified position. Typically, the magnetic actuator generates an adjustment force to adjust a position or a compensation force to counterbalance a required force (e.g. gravity), or both.

In the prior art, the actuator is of the so-called Lorentz-type, which uses a magnetic force to keep a load at a well-specified position, or to adjust that position due to a change of the actual load. The generation of the magnetic force by this type of actuator is based on the principle given by Lorentz for the relation between a charged particle, it's movement and an external magnetic field.

Disadvantageously, during the actual operation of the actuator, such an actuator uses an electric current in a conducting coil to generate the magnetic force and at the same time creates a continuous heat dissipation. The heat dissipation may cause a temperature change in the system part in which the actuator is located. The stability of the support may be adversely influenced by thermal drift or thermal expansion (and / or thermal stress) due to a temperature change by the dissipation.

Furthermore, it is noted in case a magnetic actuator from the prior art is to be used for achieving a magnetic levitation of an object, the matter is more complicated since compensating gravity constantly during movement of the object under levitation, requires a continuous change of the amplitude of the current creating the magnetic field. An increase of that current may cause a demagnetisation effect in the actuator. Also, the dissipation for creating a levitation effect will be relatively large and may cause thermal problems with other parts near the Lorentz actuator(s). Also, during levitation relatively high accelerations may occur in the mechanical parts of the actuator which may cause large disturbance forces and possibly, related damage in those mechanical parts.

Another type for creating adjustment forces is an actuator based on the piezoelectric principle, wherein actuator comprises a piezoelectric crystal and a electrically induced displacement in a piezoelectric crystal is applied to change a position of the actuator. Although their dissipation is small compared to that for Lorentz-type actuators, piezoelectric actuators disadvantageously have a relatively small actuating range, due to the limited value of the piezoelectric effect. Also, piezoelectric actuators are not suitable for creating levitation of an object.

In a continuous effort to create lithographic projection apparatuses with a capability to define patterns with increasingly smaller features, the wavelength of the radiation beam has reduced to increasingly lower values. At present, a typical wavelength is 157 nm, which is in the (deep) ultra-violet part of the electromagnetic spectrum (UV). It is noted that a smaller wavelength in the UV range is possible (e.g., 126 nm) or in the extreme ultra-violet (EUV) in the range of 5-20 nm.

It is observed that the mechanical and thermal stability of the lithographic projection apparatus must remain below values that no influence of heat dissipation by actuators is detected in the performance of the apparatus. By going to increasingly lower values of feature sizes to be exposed and by going to increasingly lower values of the radiation wavelength of the lithographic projection apparatus, the requirements for adjusting actuators with better thermal and mechanical stability increase accordingly.

It is a object of the present invention to provide an actuator with an improved performance with respect to dissipation.

This and other objects are achieved according to the invention in a magnetic actuator for controlling a magnetic force on a load as specified in the preamble of claim 1, characterised in that
the magnetic actuator is provided with a displacing element (PE;) attached to the first (M1;) and second (M2; ) magnetic element, for relatively displacing the first and second magnetic element.

It should be noted that a magnetic element may represent a permanent magnet but also an element made of ferromagnetic material. It should also be noted that the displacing element may comprise a piezoelectric element but may also comprise, as an example, an hydraulic or pneumatic or magneto-strictive element capable of providing a relative displacement between the first and second actuating part. In general, any actuator that may provide a volume change may be suited as a displacing element in this application. This volume change can also be based on thermal expansion or on a phase transition of a chemical substance.

Moreover, the present invention relates to a magnetic actuator for controlling an adjustment force as specified in claim 1, wherein the first magnetic element and the second magnetic element being arranged adjacent to each other in the first direction and being separated by a first gap, the displacing element being arranged for displacing the first magnetic element relative to the second magnetic element in the first direction to generate the adjustment force in the first direction upon a change of the magnetic interaction between the first actuating part and the second actuating part.

Moreover, the present invention relates to a support system as defined in the preamble of claim 9 comprising a magnetic actuator as described above.

Furthermore, this and other objects are achieved according to the invention in a lithographic projection apparatus as specified in the preamble of claim 10, provided with a magnetic actuator as described above.

According to a further aspect of the invention there is provided a device manufacturing method as defined in the preamble of claim 12, characterised by providing a magnetic actuator as described above.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The person skilled in the art will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

### Brief description of drawings

Below, the invention will be explained with reference to some drawings, which are intended for illustration purposes only and not to limit the scope of protection as defined in the accompanying claims.
Figure 1 depicts a lithographic projection apparatus;
Figure 2 shows schematically a cross section of a magnetic actuator according to a first embodiment of the present invention;
Figure 3 shows a second alternative embodiment of the magnetic actuator according to the present invention;
Figure 4a shows a top view of the magnetic actuator according to a third embodiment;
Figure 4b shows a fourth embodiment of the magnetic actuator according to the present invention;
Figure 4c shows an alternative arrangement of the fourth embodiment of the magnetic actuator according to the present invention.
Figure 4d shows a fifth embodiment of the magnetic actuator according to the present invention;
Figure 4e shows an alternative magnet arrangement for the first embodiment according to the present invention.
Figure 5 shows a sixth alternative embodiment of the magnetic actuator according to the present invention for use as a magnetic actuator acting in a substantially horizontal direction;
Figure 6 shows, for background purposes, a magnetic actuator for use as piezoelectric actuated reluctance motor;
Figure 7 shows schematically a graph of the magnetic force as function of the position of the moving part of the magnetic actuator of Figure 6

### Description of preferred embodiments

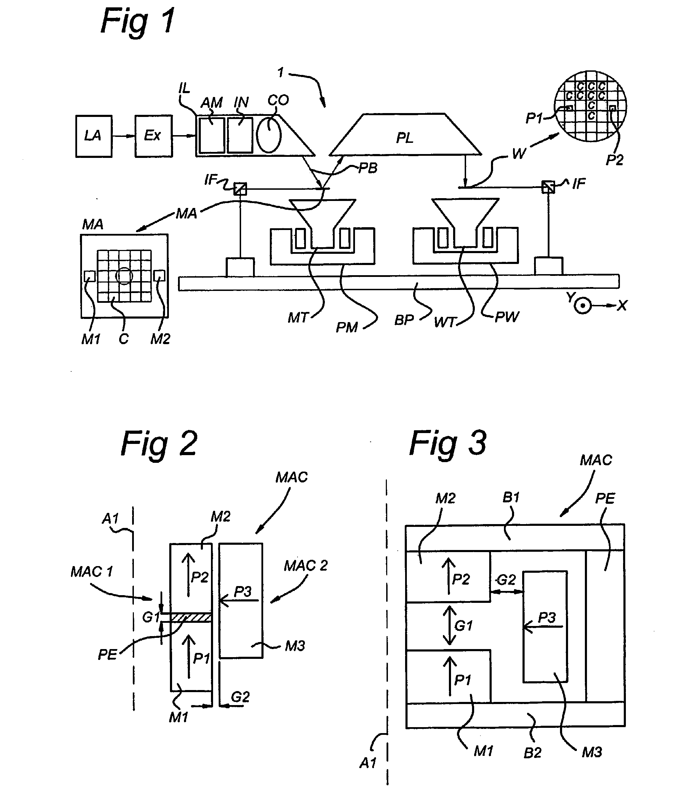

Figure 1 schematically depicts a lithographic projection apparatus 1 according to a particular embodiment of the invention. The apparatus comprises:
- a radiation system Ex, IL, for supplying a projection beam PB of radiation (e.g. UV radiation). In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL; and
- a projection system ("lens") PL for imaging an irradiated portion of the mask MA onto a target portion C (e.g. comprising one or more dies) of the substrate W.

As here depicted, the apparatus is of a reflective type (i.e. has a reflective mask). However, in general, it may also be of a transmissive type, for example (with a transmissive mask). Alternatively, the apparatus may employ another kind of patterning means, such as a programmable mirror array of a type as referred to above.

The source LA (e.g. a mercury lamp or an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realised with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (i.e. a single "flash") onto a target portion C. The substrate table WT is then shifted in the X- and/or Y-direction so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the Y-direction) with a speed v, so that the projection beam PB is caused to scan over a mask image; concurrently, the substrate table WT is simultaneously moved in the same or opposite direction at a speed V = M *v*, in which M is the magnification of the lens PL (typically, M = 1/4 or 1/5). In this manner, a relatively large target portion C can be exposed, without having to compromise on resolution.

Figure 2 shows schematically a cross section of a magnetic actuator MAC according to a first embodiment of the present invention.

In the magnetic actuator MAC according to this first embodiment, a first, second and third permanent magnet M1, M2, M3 are shown, of which each has e.g., an annular shape arranged symmetrically about a common central axis A1. Between the first and second magnet M1, M2 a piezoelectric element PE is located. The first and second magnets M1, M2 and piezoelectric element PE are combined as a first actuating part MAC1 of the magnetic actuator MAC. The third magnet M3 is part of the second actuating part MAC2.

The piezoelectric element PE is arranged between both magnets M1, M2 in such a way, that the first and second magnets M1, M2 can still be displaced, relative to each other, in a direction parallel to the central axis A1.

The first and second magnets M1, M2 are arranged in such a way that the first magnetic polarisation P1 of the first and the second magnetic polarisation P2 of the second magnet are substantially parallel as designated by the respective arrows P1, P2. Further, the third magnetic polarisation P3 of the third magnet M3 is substantially perpendicular to the direction of the first and second magnetic polarisation P1, P2, as designated by the arrow P3. Now the effect of the present invention for generating an adjustment force will be explained with reference to Figure 2.

The first magnet M1 is located with a first end surface at a certain distance G from a second end surface of the second magnet M2 in such a way that there is a gap between the low end surfaces in which the piezoelectric element PE is located.

The magnetic force from the interaction of the magnetic fields of the three magnets is dependent on the relative positions of the three magnets in this embodiment as will be known by persons skilled in the art: over the gap the magnetic flux of first magnet M1 and the magnetic flux of second magnet M2 interact, yielding in dependence of the actual gap distance, a certain overall magnetic field of the first and second magnets M1, M2. The magnetic force of the three magnets M1, M2, M3 results from the interaction of the overall magnetic field of the arrangement of the first and second magnets (at a given gap distance) in the first actuating part MAC1 and the magnetic field of the third magnet M3 in the second actuating part MAC2.

The relative positions of the two magnets M1, M2, can be altered by changing the gap distance G.

In a certain position, the magnetic actuator MAC with a load (not shown) coupled to either the first actuating part MAC1 or the second actuating part MAC2, is in a steady state: in other words the net force (the difference between the magnetic force of the magnetic actuator MAC and the force exerted by the load) is substantially zero.

The magnetic force generated in the arrangement of the three magnets M1, M2, M3 counterbalances the force exerted by the load on the part of the magnetic actuator MAC to which the load is attached. In this state, the load is situated at a given position. To relocate the load from this position to one other position, a change of the magnetic force must be generated for relocating the load. The magnetic force can be altered by changing the gap distance G between the first and second magnets M1, M2.

The change of the gap distance causes a change of overall magnetic field of the first actuating part MAC1. When this overall magnetic field changes relative to the magnetic field from the third magnet M3, the magnetic force of the magnetic actuator MAC no longer counterbalances the force by the load.

Depending on the change of the gap distance G, the change of the overall magnetic field of the first actuating part may be such that the magnetic force yields a net force in upward or downward direction. Due to this net force the load will move in the direction of the net force.

As soon as the desired new position is reached the gap distance G between the first and second magnets is changed in such a way that the magnetic force again counterbalances the force due to the load. The load will now remain at the newly chosen position. The relation between force and movement (or position) will be explained later in more detail.

It is noted that a controller (not shown) preferably arranged in a closed loop is to be provided to ensure that the movement of the moving part takes place in a controlled way. The controller comprises a position detector (not shown) which detects the position of the moving part relative to the fixed part of the actuator, and a processing unit (not shown) that reads a position signal from the position detector for determining the position of the moving part of the actuator. Further, the controller is electrically connected (not shown) to the piezoelectric element PE in a manner known to persons skilled in the art. The controller is arranged to control the piezoelectric element PE in such a way that upon reaching the newly chosen position, the dimension of the piezoelectric element in the direction of the gap distance is altered for counterbalancing the magnetic force again with the force due to the load. The net force becomes substantially zero by this action of the controller. It is noted that the position detector of the controller may be arranged for detecting a indirect position signal (e.g., a signal related to a magnetic flux) from which a position signal can be derived.

Mechanically, the magnetic actuator MAC has a low stiffness. This means that the magnetic force acting on either MAC1 or on magnet M3 remains almost constant for a displacement (or stroke) of MAC1 relative to M3 (in a vertical direction). A stiffness of ~200N/m (0.2N/mm) can be obtained over a stroke of a few mm. This means that only a small variation in net force is required to displace MAC1 relative to M3. This force variation is realised by altering the gap G. The magnetic actuator force is very sensitive for variations in this gap G: Relatively large force variations occur as a function of a relatively small variation of the gap distance G. A variation in gap distance by 5-6 µm results in a force variation of approximately 0.15 N which is sufficient to move the load over more than 0.5 mm when the stiffness is ∼200 N/m.

Since only the piezoelectric element PE needs to be controlled for changing the gap distance to adjust the magnetic force, the dissipation is very low in the magnetic actuator MAC according to the present invention. Advantageously, thermal effects such as thermal expansion and thermal drift can be substantially reduced by the magnetic actuator MAC according to the present invention. A further advantage of the low stiffness of the actuator is that this low stiffness provides a vibration isolation between both parts, i.e. MAC1 and MAC2. Due to the low stiffness, vibration of one of these parts will only have a small effect on the other part since the generated force between both parts is substantially independent of the relative position of both parts in the operating range.

The magnetic actuator MAC can be arranged on a base part of the lithographic projection apparatus (not shown) from which an element i.e., a part of the lithographic projection apparatus, is supported. The magnetic actuator MAC may be attached to the base part by either the first actuating part MAC1 or the second actuating part MAC2 comprising the third magnet M3.

The base may be attached to a floor part on which the apparatus is installed, in which case the element to be supported could be an isolated reference frame, or the base part may be a dynamic component such as a short-stroke module or a long-stroke module used in a suspension for a gravitational load within the lithographic projection apparatus. The element supported may also be an optical element such as a mirror or a lens. It should be noted that it is advantageous to provide such a support system with three actuators for supporting the object in vertical position, the actuators approx. being arranged in a triangle in a plane perpendicular to the support direction. In such arrangement, the object can be positioned in vertical position (Z-direction) but can also be tilted in the X- and Y-direction.
Figure 3 shows a second alternative embodiment of the magnetic actuator MAC. In this embodiment, items are referred to with the same references as in Figure 1 and 2.

In this second alternative embodiment the magnetic elements M1, M2 and M3 again have an annular shape as in the first embodiment. The piezoelectric element PE has an annular shape and is positioned around both first and second magnets M1, M2. The piezoelectric element PE is linked to the first and second magnets M1, M2 by a frame comprising an upper disk B1 attached to an upper end of the piezoelectric element PE and the top outer end of the first magnet M1, and a lower disk B2 attached to a lower end of the piezoelectric element PE and the bottom outer end of the second magnet M2. The third magnet M3 is positioned in between the first and second magnets M1, M2 on one side and the piezoelectric element PE on the other side.

Advantageously, in the second embodiment the working length of the piezoelectric element is larger and the actuating displacement can be larger.

In the second embodiment, the magnet M3 can be connected to the base through holes that are made in the discs B1, B2.

Persons skilled in the art will appreciate that by the use of mechanical elements, such as disks B1 and B2, the stiffness of the arrangement will be increased and result in a damping of the actuating operation. Preferably, application of mechanical elements in the actuator, that may influence the stiffness of the actuator, should be kept to a minimum.

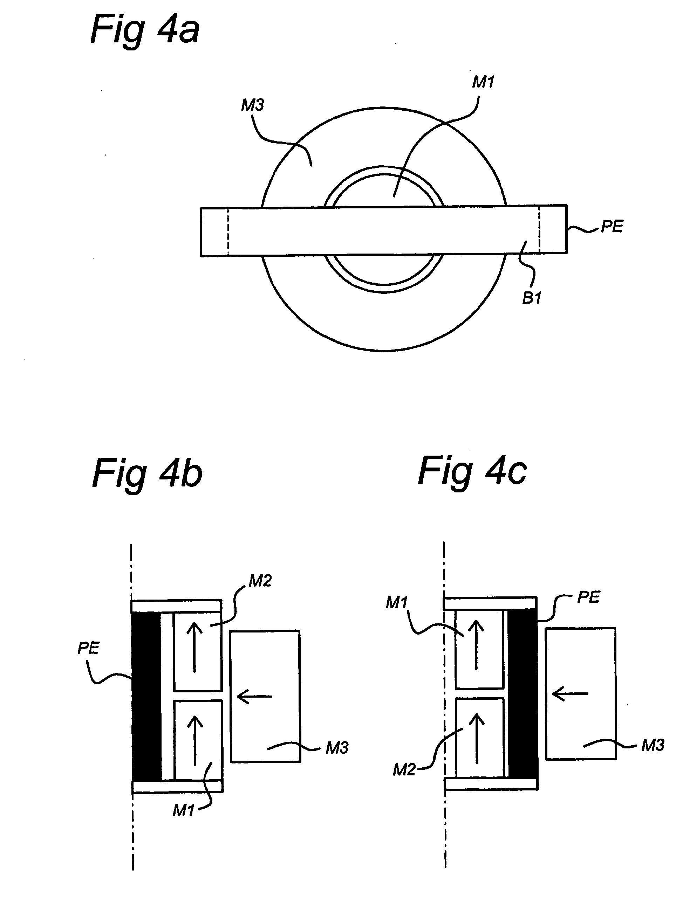

Figure 4a shows a top view of the magnetic actuator according to a third embodiment.

Alternatively, in the third embodiment, in stead of an annular piezoelectric element PE a discrete set of piezoelectric elements can be used in stead of a complete cylindrical PE. e.g., by using two piezoelectric elements and connect these through an upper beam and a lower beam.

In a further fourth embodiment comprising annular magnets M1, M2, M3 with a common central axis A1, the piezoelectric element PE is located in a cylindrical cavity being formed along the common central axis A1 within the first and second magnets M1, M2. (see Figure 4b) The piezoelectric element PE is connected with one outer end to an outer end of the first magnet remote from the gap G and with another outer end to the outer end of the second magnet remote from the gap. The working length of the piezoelectric element PE equals in this fourth embodiment the length of the first magnet, the length of the second magnet plus the gap distance between the first and second magnet. Advantageously, the working length in the fourth embodiment is larger than the working length in the first embodiment, and thus provides a larger actuating range than in the first embodiment. Alternatively, the piezoelectric element PE may be located within the gap between the first actuating part MAC1 and the second actuating part MAC2 (see figure 4c).

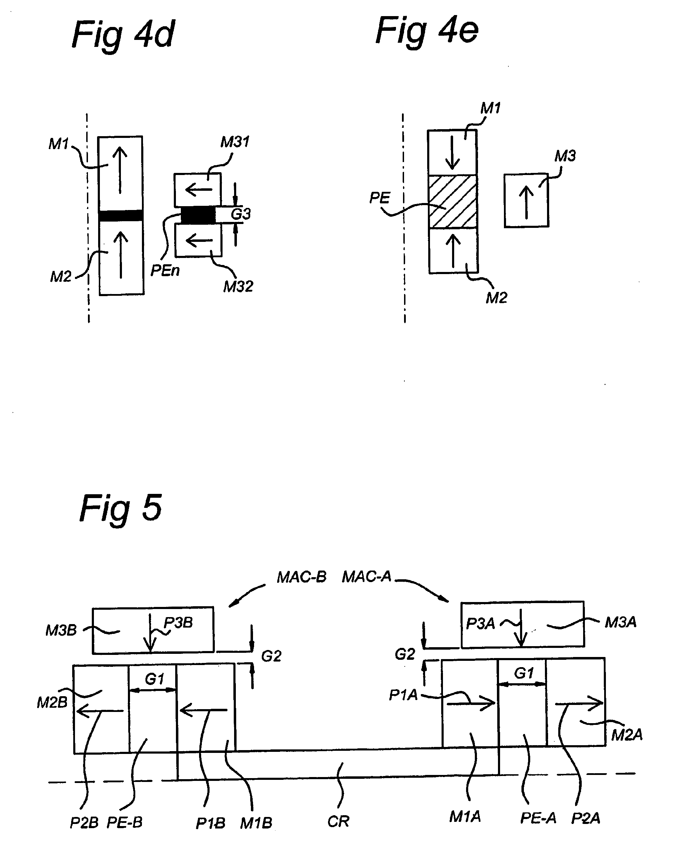

A further fifth embodiment of the magnetic actuator (Figure 4d) may be based on the arrangement of the first, second and third magnets M1, M2, M3. In this arrangement the third magnet M3 is subdivided in an upper M31 and a lower part M32 by a gap G3. Within this gap of the third magnet M3 a plurality of piezoelectric elements PEn is present, preferably three piezoelectric elements with an enclosed angle of 120 ° in the horizontal plane between the piezoelectric elements. In this embodiment, the upper part of the third magnet can be tilted relative to the lower part of the third magnet by generating a different displacement for each piezoelectric element within the gap. This allows generating a couple, perpendicular to the direction of the common central axis, and a magnetic force which can be directed in a direction tilted with respect to the direction of the common central axis A1. In this embodiment, the third magnet M3 may actually be divided in two separate parts, or it may comprise slits within the body of magnet M3, wherein each slit is arranged for accepting a piezoelectric element. It will be clear to a person skilled in the art that alternative arrangements for the piezoelectric elements as shown in figure 4b and 4c can also be applied for the piezoelectric elements separating the magnet M3 in the embodiment of figure 4d. It should further be noted that in this fifth embodiment the first actuator part MAC1 may comprise of a single magnet since the generated magnetic force can be adjusted by means of the piezoelectric elements separating the upper and lower part of the magnet M3. It should be noted that the magnet arrangement as shown in figures 2 to 4d (i.e. a first assembly comprising two magnets magnetised along a first direction and enclosed by a second assembly comprising a magnet that is magnetised perpendicular to said first direction) is only one of many possibilities for generating a magnetic force that remains substantially constant over an operating range. Figure 4e shows an alternative arrangement wherein the first actuating part comprises two annular shaped permanent magnets M1, M2 having an opposite magnetic polarisation parallel to the first direction, the second actuating part comprises a annular permanent magnet M3 that is also polarised in the first direction. The actuating force can be generated by altering the gap between the first and second magnet by the piezoelectric element PE situated in the gap.

Figure 5 shows a sixth alternative embodiment of the magnetic actuator MAC for use as a magnetic actuator acting in a substantially horizontal direction. In this sixth alternative embodiment the magnetic actuator MAC is used to produce a displacement in a horizontal direction.

The magnetic actuator of this embodiment comprises two magnetic actuators MAC-A and MAC-B which each comprise first, second and third magnetic elements M1A, M2A, M3A, and M1B, M2B, M3B, respectively, and a piezoelectric element PE-A and PE-B, respectively. The magnetic elements M1A, M2A, M3A, M1B, M2B, and M3B each comprise a magnetic polarisation P1A, P2A, P3A, P1B, P2B and P3B, respectively. Further, the magnetic actuators MAC-A and MAC-B are connected by an connection rod CR. The magnetic polarisation of the first and second magnets of magnetic actuator MAC-A (P1A, P2A) is directed in the opposite direction of the magnetic polarisation of the first and second magnets of magnetic actuator MAC-B (P1B, P2B) to counterbalance the magnetic force of magnetic actuator MAC-A and magnetic actuator MAC-B relative to each other.

The net force for generating a displacement results from the difference in the magnetic force of each of the magnetic actuators MAC-A and MAC-B. In both magnetic actuators the magnetic force can be changed by the piezoelectric element PE of the respective magnetic actuator. (Alternatively, in this sixth embodiment only one of the piezoelectric elements PE-A or PE-B may be present, in the other magnetic actuator the piezoelectric element can be omitted with the first and second magnet in the respective actuator remaining at a fixed position relative to each other.)

Although the embodiments shown in figures 2 to 5 apply permanent magnets with an annular shape, it should be noted that this is not an absolute requirement. It should be noted that a magnetic actuator as described in figures 2 to 5 may also comprise magnets having a non-annular shape such as rectangular or square shaped magnets.

The principle of the present invention to generate a magnetic force in response to a piezoelectric actuator, as disclosed above can also be applied in a piezoelectric actuated reluctance motor (or magnetic bearing).

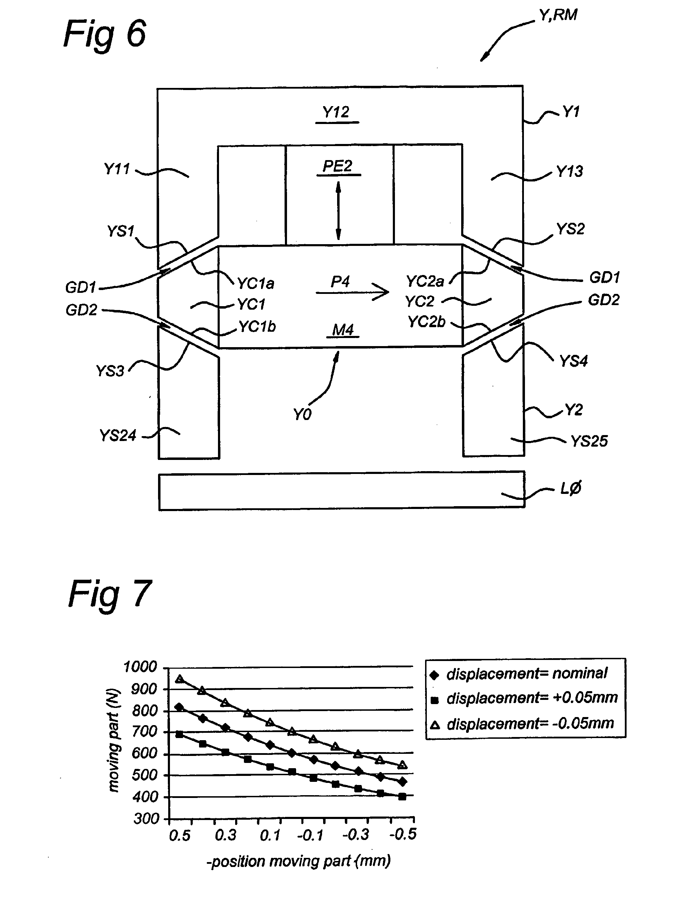

Figure 6 shows, for background purposes, a piezoelectric actuated reluctance motor.

The reluctance motor RM consists of a first actuating part (i.e. the yoke Y) comprising a ferromagnetic material and a second actuation part (L0) also comprising a ferromagnetic material. The yoke Y comprises an upper part Y1, a lower part Y2, and an intermediate part Y0 in between Y1 and Y2. The first part Y1 comprises a first subpart Y11, a middle subpart Y12 and a third subpart Y13. The first subpart Y11 at its free end has a slant surface YS1. The third subpart Y13 has a slant surface YS2 at its free end.

Similarly, the lower part Y2 of the yoke Y comprises a fourth and a fifth subpart Y24, Y25. Both fourth and fifth subpart Y24, Y25 have a slant surface YS3, YS4, at their respective end directed towards the intermediate yoke part Y0.

The intermediate part Y0 consists of a permanent magnet M4, a first guiding part YC1 and a second guiding part YC2 each with a slant surface YCS1a, YCS1b, YCS2a, YCS2b, respectively, corresponding with the slant surface YS1, YS2, YS3 and YS4 respectively, for guiding the magnetic field of the permanent magnet M4 to the other parts of the yoke. The magnetic polarisation P4 of the permanent magnet M4 is indicated by the arrow P4.

Between the slanted surface YCS1a of the first guiding part YC1 and the surface YS1 of the first subpart Y11 of the first yoke part Y1, and correspondingly, between YCS2a and YS2 a first gap distance GD1 is provided. Also, a second gap distance GD2 is provided between the slanted surface YCS1b of the first guiding part YC1 and the surface YS3 of the fourth subpart Y24 of the second yoke part Y2, and correspondingly, between YCS2b and YS4.

Further, the reluctance motor RM comprises a piezoelectric element PE2, which is connected to the sidewall of the permanent magnet M4 and to the sidewall of the second subpart Y12 of the upper first part Y1 of the yoke.

Below the lower part Y2 of the yoke, a load (i.e., an object to be lifted to or positioned at a given position under the yoke) may be attached to the second actuating part (not shown).

The upper first part Y1 and the lower second part Y2 of the yoke are at fixed positions relative to each other. The first part Y1 and the second part Y2 may be connected by a connecting part (not shown) which comprises a material that is nonmagnetic and preferably non-conducting, e.g., a plastic or ceramic.

The intermediate part Y0 of the yoke is arranged for movement in upward or downward direction within the range given by the first and second gap distances GD1, GD2. It is noted that the intermediate part Y0 may be arranged in such a way that actual physical contact to either the upper first part Y1 or the lower second part Y2 is prevented. The magnetic field of the permanent magnet M4 induces magnetic fields in the other parts Y1, Y2, YC1 and YC2 of the yoke Y.

The piezoelectric element PE2 is arranged for changing the first gap distance GD1 and second gap distance GD2 relative to each other. By the actual position of the intermediate part Y0, the first gap distance GD1 and the second gap distance GD2 are set.

The actual magnetic flux (i.e., field strength per unit area) over the respective gap distance can be influenced by changing the ratio between the first gap distance GD1 and the second gap distance GD2. Due to the interaction of the magnetic fluxes, similar as in the first, second, third, fourth, fifth and sixth embodiment of the magnetic actuator MAC as disclosed above, a magnetic force is created which is capable to position the load L0 at a certain given position below the second yoke part Y2. Furthermore, by changing the gap distance ratio through a dimensional change of the piezoelectric actuator PE2, the magnetic force can be varied to change the position of load attached to the second actuating part L0 to either a closer or more distant position relative to the lower part Y2 of the yoke Y. A person skilled in the art will appreciate that the upper part Y1 of the yoke may be omitted while the magnetic actuator remains still functional: by changing the second gap distance GD2 it is still possible to control the magnetic force acting on the load. It is however noted that this control is more complicated to achieve than when the upper part Y1 of the yoke is present and two counteracting magnetic fluxes exist (over the first and second gap distance, respectively): operation of such a magnetic actuator without an upper part Y1 of the yoke is less effective.

In Figure 7 the relation between the movement of the moving part of the magnetic actuator of Figure 6 and the magnetic force is illustrated. It is noted however, that as is apparent to persons skilled in the art, that similar relations describing the generated magnetic force as a function of the displacement of the piezoelectric element and as a function of the displacement of the load, can be calculated for the other embodiments as well.

Figure 7 shows schematically a graph of the magnetic force as function of the position of the second actuating part L0 of the magnetic actuator of Figure 6 for different displacements of the piezoelectric element.

In this graph the magnetic force is plotted in the vertical direction as a function of the position of the moving part of the actuator in the horizontal direction. The force-position relationship shown here is determined by means of a (finite element method) simulation.

Three function curves were plotted each for a different displacement caused by the piezoelectric element PE2 of the actuator. In this example, the displacement is either nominal, i.e., at steady state position of 0.0 mm, or in this graph, at -0.05 or at 0.05 mm below or above the nominal position, respectively.

The upper function curve represents the force-position curve for a displacement of the piezoelectric element of -0.05 mm.

The middle function curve represents the force-position curve for a displacement of the piezoelectric element of 0.0 mm.

The lower function curve represents the force-position curve for a displacement of the piezoelectric element of +0.05 mm.

The magnetic force is calculated here per meter length of the actuator.

The force response in each function curve is calculated over a range from -0.5 to +0.5 mm for the stroke of the moving part around the nominal position.

Assuming in this exemplary illustration a weight of the moving part and an attached load of 600 N, the magnet of the moving part can be kept at its nominal position. The weight is exactly counterbalanced by the magnetic force.

When the permanent magnet M4 in the intermediate yoke part Y0 moves to, for example, the position of -0.05 mm (upper curve) the attractive force increases to approximately 700 N (for a moving part in a nominal position) and the moving part will move up due to the difference of the magnetic force and the weight: a net force of approximately 100 N acts upon the moving part of the actuator when it is in the nominal position. When the mover moves upwards, the net force will increase even further.

When the magnet moves to, for example the position of +0.5 mm, the attractive force increases to approximately 800 N and the moving part may move up even further due to the difference of the magnetic force and the weight: a net force of approximately 200 N acts upon the moving part of the actuator.

From Figure 7 it can be deduced that the maximum allowable stroke position is approximately -0.3 mm and +0.3 mm in downward and upward direction, respectively. With a piezoelectric displacement of -0.05 mm (upper curve) below the nominal position (0.0 mm), a magnetic force of 600 N can be generated with the moving part in position -0.3 mm. Note that this is the lowest position in which the load can be retrieved. Below this position, the moving part (and the load) can not be stopped any more and will drop. With a piezoelectric displacement of +0.05 mm (lower curve) above the nominal position (0.0 mm), a magnetic force of 600 N can be generated with the moving part in position +0.3 mm. Note that this is the highest possible position. If the load moves higher, it cannot be stopped but will be pulled against the yoke. So, the operational stroke of the moving part is roughly six times larger than the stroke produced by the piezoelectric element. It is noted that the effect of disturbances and accelerations of the moving part of the actuator are not taken in account in the discussion of the maximum allowable stroke. At the maximum allowable stroke, the net force is substantially zero, no force to counteract the disturbance or acceleration is available at that point. The maximum allowable stroke is an upper-bound: the net force must be non-zero to handle accelerations. Consequently, the maximum stroke which allows counteracting accelerations will be smaller than the maximum allowable stroke as described above.

It is noted that optimisation of the working principle for a given size of the magnetic actuator can be focussed on either the actual generated magnetic force or the magnitude of the operational stroke. A trade-off occurs in the combination of force and stroke as will be appreciated by persons skilled in the art. Thus, the principle can be used in one respect for magnetic bearings (large force and short stroke) and in another respect for short stroke motors (small force and comparatively large stroke).

Moreover, it is noted that although the working principle relates to all embodiments shown, the first, second, third, fourth, fifth and sixth embodiments may be more suited for applications comprising small force variations, while the actuator shown in Figure 6 may be more suited for applications comprising relatively larger force variations. An application for the first, second and third embodiments is e.g., positioning of optical elements (lenses, mirrors, beam splitters, etc.). An application for the actuator shown in Figure 6 is e.g., a short-stroke motor or a magnetic bearing.

Finally, the magnetic actuator according to the present invention as described above relates to a translational system. It is noted that the magnetic actuator of the present invention may also be implemented for rotational systems.

Persons skilled in the art will appreciate that other alternative and equivalent embodiments of the invention can be conceived and reduced to practice without departing form the true spirit of the invention, the scope of the invention being limited only by the appended claims.

## Claims

1. Magnetic actuator (MAC) for adjusting a force on a load, comprising a first actuating part (MAC1) and a second actuating part (MAC2),
the first actuating part comprises a first magnetic element (M1) and a second magnetic element (M2), the second actuating part (MAC2) comprises a third magnetic element (M3), the first and second actuating part are constructed and arranged to generate a magnetic force between both parts in a first direction, the load being attached to either the first or second actuating part, wherein
the magnetic actuator is provided with a displacing element (PE) attached to the first
(M1) and second (M2) magnetic element, for relatively displacing the first and second magnetic element, **characterised in that** the first, second and third magnetic element comprise a respectively first, second and third permanent magnet, whereby a magnetic polarization of the third permanent magnet is substantially perpendicular to a magnetic polarization of the first and second permanent magnet when the first and second permanent magnet are polarized in the same sense or, whereby a magnetic polarization of the third permanent magnet is substantially parallel to a magnetic polarization of the first and second permanent magnet when the first and second permanent magnet are polarized in opposite sense.

2. Magnetic actuator (MAC) according to claim 1, **characterized in that** the displacing element (PE) comprises a piezoelectric element.

3. Magnetic actuator (MAC) according claim 1 or 2, wherein the first magnetic element and the second magnetic element being arranged adjacent to each other in the first direction and being separated by a first gap (G1), the displacing element (PE) being arranged for displacing the first magnetic element (M1) relative to the second magnetic element (M2) in the first direction to generate the adjustment force in the first direction upon a change of the magnetic interaction between the first actuating part (MAC1) and the second actuating part (MAC2).

4. Magnetic actuator according to claim 3, **characterized in that** the displacing element (PE) is located in the first gap (G1)

5. Magnetic actuator according to claim 3, **characterized in that** the first magnetic element (M1) and the second magnetic element (M2) each comprise a cavity extending in the first direction, and that the displacing element (PE) is located inside the cavity of the first magnetic element (M1) and inside the cavity of the second magnetic element (M2),
the displacing element (PE) being coupled with the first magnetic element (M1) and with the second magnetic element (M2), and having a working length substantially equal to the length of the first and second magnetic elements and the distance of the first gap (G1).

6. Magnetic actuator according to claim 3, **characterized in that** the displacing element (PE) is located adjacent to both first and second magnetic elements (M1, M2), the displacing element (PE) being coupled with the first magnetic element (M1) and with the second magnetic element (M2), and having a working length substantially equal to the length of the first and second magnetic elements and the distance of the first gap (G1).

7. Magnetic actuator according to claim 6, **characterized in that** for the coupling to the first magnetic element (M1) a first coupling element (B1) is provided, and for the coupling of the second magnetic element (M2) a second coupling element (B2) is provided.

8. Magnetic actuator (MAC) according to the preceding claims 1 to 7,
**characterized in that** the magnetic elements comprise non-magnetisable material, such as a carbon based polymer or ceramic.

9. Support system provided with a magnetic actuator (MAC) according to any of the preceding claims.

10. A lithographic projection apparatus comprising:
a radiation system for providing a projection beam of radiation;
a support structure for supporting patterning means, the patterning means serving to pattern the projection beam according to a desired pattern;
a substrate table for holding a substrate; and
a projection system for projecting the patterned beam onto a target portion of the substrate,
provided with a magnetic actuator according to any of the preceding claims 1 to 8.

11. A lithographic projection apparatus comprising:
a radiation system for providing a projection beam of radiation;
a support structure for supporting patterning means, the patterning means serving to pattern the projection beam according to a desired pattern;
a substrate table for holding a substrate; and
a projection system for projecting the patterned beam onto a target portion of the substrate,
provided with a support system according to claim 9.

12. A device manufacturing method comprising the steps of:
providing a substrate that is at least partially covered by a layer of radiation-sensitive material;
providing a projection beam of radiation using a radiation system;
using patterning means to endow the projection beam with a pattern in its cross-section; and
projecting the patterned beam of radiation onto a target portion of the layer of radiation-sensitive material,
**characterized by**
providing a projection system with a magnetic actuator according to any of the preceding claims 1 to 8.

## Patentansprüche

1. Magnetisches Betätigungsglied (MAC) zum Einstellen einer Kraft auf eine Last, das einen ersten Betätigungsteil (MAC1) und einen zweiten Betätigungsteil (MAC2) beinhaltet,
der erste Betätigungsteil beinhaltet ein erstes magnetisches Element (M1) und ein zweites magnetisches Element (M2), der zweite Betätigungsteil (MAC2) beinhaltet ein drittes magnetisches Element (M3), der erste und zweite Betätigungsteil sind konstruiert und eingerichtet, um zwischen beiden Teilen in einer ersten Richtung eine magnetische Kraft zu erzeugen, wobei die Last an entweder dem ersten oder dem zweiten Betätigungsteil angebracht ist, wobei das magnetische Betätigungsglied mit einem Verstellelement (PE) versehen ist, das an dem ersten (M1) und zweiten (M2) magnetischen Element angebracht ist, um das erste und zweite magnetische Element relativ zu verstellen,
**dadurch gekennzeichnet, dass**
das erste, zweite und dritte magnetische Element einen ersten, zweiten bzw. dritten Dauermagneten beinhalten, wobei eine magnetische Polarisation des dritten Dauermagneten zu einer magnetischen Polarisation des ersten und zweiten Dauermagneten im Wesentlichen senkrecht ist, wenn der erste und zweite Dauermagnet in der gleichen Richtung polarisiert sind, oder wobei eine magnetische Polarisation des dritten Dauermagneten zu einer magnetischen Polarisation des ersten und zweiten Dauermagneten im Wesentlichen parallel ist, wenn der erste und zweite Dauermagnet in der entgegengesetzten Richtung polarisiert sind.

2. Magnetisches Betätigungsglied (MAC) gemäß Anspruch 1, **dadurch gekennzeichnet, dass** das Verstellelement (PE) ein piezoelektrisches Element beinhaltet.

3. Magnetisches Betätigungsglied (MAC) gemäß Anspruch 1 oder 2, wobei das erste magnetische Element und das zweite magnetische Element in der ersten Richtung nebeneinander eingerichtet sind und durch eine erste Lücke (G1) getrennt sind, wobei das Verstellelement (PE) eingerichtet ist, um das erste magnetische Element (M1) relativ zu dem zweiten magnetischen Element (M2) in der ersten Richtung zu verstellen, um bei einer Änderung der magnetischen Wechselwirkung zwischen dem ersten Betätigungsteil (MAC1) und dem zweiten Betätigungsteil (MAC2) die Einstellkraft in der ersten Richtung zu erzeugen.

4. Magnetisches Betätigungsglied gemäß Anspruch 3, **dadurch gekennzeichnet, dass** sich das Verstellelement (PE) in der ersten Lücke (G1) befindet.

5. Magnetisches Betätigungsglied gemäß Anspruch 3, **dadurch gekennzeichnet, dass** das erste magnetische Element (M1) und das zweite magnetische Element (M2) jeweils einen Hohlraum beinhalten, der sich in der ersten Richtung erstreckt, und dass sich das Verstellelement (PE) innerhalb des Hohlraums des ersten magnetischen Elements (M1) und innerhalb des Hohlraums des zweiten magnetischen Elements (M2) befindet, wobei das Verstellelement (PE) mit dem ersten magnetischen Element (M1) und mit dem zweiten magnetischen Element (M2) gekoppelt ist und eine Arbeitslänge aufweist, die im Wesentlichen gleich der Länge des ersten und zweiten magnetischen Elements und der Distanz der ersten Lücke (G1) ist.

6. Magnetisches Betätigungsglied gemäß Anspruch 3, **dadurch gekennzeichnet, dass** sich das Verstellelement (PE) sowohl neben dem ersten als auch neben dem zweiten magnetischen Element (M1, M2) befindet, wobei das Verstellelement (PE) mit dem ersten magnetischen Element (M1) und mit dem zweiten magnetischen Element (M2) gekoppelt ist und eine Arbeitslänge aufweist, die im Wesentlichen gleich der Länge des ersten und zweiten magnetischen Elements und der Distanz der ersten Lücke (G1) ist.

7. Magnetisches Betätigungsglied gemäß Anspruch 6, **dadurch gekennzeichnet, dass** für die Kopplung mit dem ersten magnetischen Element (M1) ein erstes Kopplungselement (B1) bereitgestellt ist und für die Kopplung des zweiten magnetischen Elements (M2) ein zweites Kopplungselement (B2) bereitgestellt ist.

8. Magnetisches Betätigungsglied (MAC) gemäß den vorhergehenden Ansprüchen 1 bis 7, **dadurch gekennzeichnet, dass** die magnetischen Elemente ein nicht magnetisierbares Material wie etwa ein kohlenstoffbasiertes Polymer oder eine Keramik beinhalten.

9. Ein Stützsystem, das mit einem magnetischen Betätigungsglied (MAC) gemäß einem der vorhergehenden Ansprüche versehen ist.

10. Ein lithographisches Projektionsgerät, das Folgendes beinhaltet:
ein Strahlungssystem zum Bereitstellen eines Projektionsstrahls aus Strahlung;
eine Stützstruktur zum Stützen eines Musteraufbringungsmittels, wobei das Musteraufbringungsmittel dazu dient, den Projektionsstrahl gemäß einem gewünschten Muster zu mustern;
einen Substrattisch zum Halten eines Substrats; und
ein Projektionssystem zum Projizieren des gemusterten Strahls auf einen Zielabschnitt des Substrats,
versehen mit einem magnetischen Betätigungsglied gemäß einem der vorhergehenden Ansprüche 1 bis 8.

11. Ein lithographisches Projektionsgerät, das Folgendes beinhaltet:
ein Strahlungssystem zum Bereitstellen eines Projektionsstrahls aus Strahlung;
eine Stützstruktur zum Stützen eines Musteraufbringungsmittels, wobei das Musteraufbringungsmittel dazu dient, den Projektionsstrahl gemäß einem gewünschten Muster zu mustern;
einen Substrattisch zum Halten eines Substrats; und
ein Projektionssystem zum Projizieren des gemusterten Strahls auf einen Zielabschnitt des Substrats,
versehen mit einem Stützsystem gemäß Anspruch 9.

12. Ein Verfahren zum Herstellen einer Vorrichtung, das die folgenden Schritte beinhaltet:
Bereitstellen eines Substrats, das mindestens teilweise durch eine Schicht aus strahlungsempfindlichem Material abgedeckt ist;
Bereitstellen eines Projektionsstrahls aus Strahlung unter Verwendung eines Strahlungssystems;
Verwenden eines Musteraufbringungsmittels, um den Projektionsstrahl in seinem Querschnitt mit einem Muster zu versehen; und
Projizieren des gemusterten Strahls aus Strahlung auf einen Zielabschnitt der Schicht aus strahlungsempfindlichem Material,
**gekennzeichnet durch**
Bereitstellen eines Projektionssystems mit einem magnetischen Betätigungsglied gemäß einem der vorhergehenden Ansprüche 1 bis 8.

## Revendications

1. Actionneur magnétique (MAC) destiné à ajuster une force sur une charge, comprenant une première partie d'actionnement (MAC1) et une deuxième partie d'actionnement (MAC2),
la première partie d'actionnement comprend un premier élément magnétique (M1) et un deuxième élément magnétique (M2), la deuxième partie d'actionnement (MAC2) comprend un troisième élément magnétique (M3), la première et la deuxième partie d'actionnement sont construites et arrangées pour générer une force magnétique entre les deux parties dans une première direction, la charge étant attachée soit à la première, soit à la deuxième partie d'actionnement, l'actionneur magnétique étant pourvu d'un élément de déplacement (PE) attaché au premier (M1) et au deuxième (M2) élément magnétique, pour déplacer de façon relative le premier et le deuxième élément magnétique,
**caractérisé en ce que**
le premier, le deuxième et le troisième élément magnétique comprennent un respectivement premier, deuxième et troisième aimant permanent, une polarisation magnétique du troisième aimant permanent étant substantiellement perpendiculaire à une polarisation magnétique du premier et du deuxième aimant permanent lorsque le premier et le deuxième aimant permanent sont polarisés dans le même sens, ou une polarisation magnétique du troisième aimant permanent étant substantiellement parallèle à une polarisation magnétique du premier et du deuxième aimant permanent lorsque le premier et le deuxième aimant permanent sont polarisés dans un sens opposé.

2. Actionneur magnétique (MAC) selon la revendication 1, **caractérisé en ce que** l'élément de déplacement (PE) comprend un élément piézoélectrique.

3. Actionneur magnétique (MAC) selon la revendication 1 ou la revendication 2, dans lequel le premier élément magnétique et le deuxième élément magnétique sont arrangés adjacents l'un à l'autre dans la première direction et sont séparés par un premier intervalle (G1), l'élément de déplacement (PE) étant arrangé pour déplacer le premier élément magnétique (M1) relativement au deuxième élément magnétique (M2) dans la première direction afin de générer la force d'ajustement dans la première direction dès changement de l'interaction magnétique entre la première partie d'actionnement (MAC1) et la deuxième partie d'actionnement (MAC2).

4. Actionneur magnétique selon la revendication 3, **caractérisé en ce que** l'élément de déplacement (PE) est situé dans le premier intervalle (G1).

5. Actionneur magnétique selon la revendication 3, **caractérisé en ce que** le premier élément magnétique (M1) et le deuxième élément magnétique (M2) comprennent chacun une cavité s'étendant dans la première direction, et **en ce que** l'élément de déplacement (PE) est situé à l'intérieur de la cavité du premier élément magnétique (M1) et à l'intérieur de la cavité du deuxième élément magnétique (M2),
l'élément de déplacement (PE) étant couplé avec le premier élément magnétique (M1) et avec le deuxième élément magnétique (M2), et ayant une longueur utile substantiellement égale à la longueur des premier et deuxième éléments magnétiques plus la distance du premier intervalle (G1).

6. Actionneur magnétique selon la revendication 3, **caractérisé en ce que** l'élément de déplacement (PE) est situé adjacent à la fois au premier et au deuxième élément magnétique (M1, M2), l'élément de déplacement (PE) étant couplé avec le premier élément magnétique (M1) et avec le deuxième élément magnétique (M2), et ayant une longueur utile substantiellement égale à la longueur des premier et deuxième éléments magnétiques plus la distance du premier intervalle (G1).

7. Actionneur magnétique selon la revendication 6, **caractérisé en ce que** pour le couplage au premier élément magnétique (M1) un premier élément de couplage (B1) est fourni, et pour le couplage du deuxième élément magnétique (M2) un deuxième élément de couplage (B2) est fourni.

8. Actionneur magnétique (MAC) selon les revendications précédentes 1 à 7, **caractérisé en ce que** les éléments magnétiques comprennent un matériau non magnétisable, tel qu'une céramique ou un polymère à base de carbone.

9. Système de support pourvu d'un actionneur magnétique (MAC) selon n'importe lesquelles des revendications précédentes.

10. Un appareil de projection lithographique comprenant :
un système de rayonnement destiné à fournir un faisceau de projection de rayonnement ;
une structure formant support destinée à supporter un moyen pour conformer selon un motif, le moyen pour conformer selon un motif servant à conformer le faisceau de projection selon un motif souhaité ;
une table porte-substrat destinée à porter un substrat ; et
un système de projection destiné à projeter le faisceau à motif sur une portion cible du substrat,
pourvu d'un actionneur magnétique selon n'importe lesquelles des revendications précédentes 1 à 8.

11. Un appareil de projection lithographique comprenant :
un système de rayonnement destiné à fournir un faisceau de projection de rayonnement ;
une structure formant support destinée à supporter un moyen pour conformer selon un motif, le moyen pour conformer selon un motif servant à conformer le faisceau de projection selon un motif souhaité ;
une table porte-substrat destinée à porter un substrat ; et
un système de projection destiné à projeter le faisceau à motif sur une portion cible du substrat,
pourvu d'un système de support selon la revendication 9.

12. Un procédé de fabrication de dispositif comprenant les étapes consistant à :
fournir un substrat qui est au moins partiellement recouvert d'une couche de matériau sensible à un rayonnement ;
fournir un faisceau de projection de rayonnement à l'aide d'un système de rayonnement ;
utiliser un moyen pour conformer selon un motif afin de doter le faisceau de projection d'un motif dans sa coupe transversale ; et
projeter le faisceau de rayonnement à motif sur une portion cible de la couche de matériau sensible au rayonnement,
**caractérisé par** le fait de
pourvoir un système de projection d'un actionneur magnétique selon n'importe lesquelles des revendications précédentes 1 à 8.
